# EUROPEAN PATENT APPLICATION

(11) **EP 2 670 051 A2**
(43) Date of publication of application: **04.12.2013**
(21) Application number: 13275122.3
(22) Date of filing: 21.05.2013
(51) Int. Cl.: H03G 3/30

(54) **Signal processing apparatus, system and method for automatic gain control using the same**

(30) Priority: 31.05.2012 KR 20120058287
(71) Applicant: Samsung Electro-Mechanics Co., Ltd., Gyeonggi-do (KR)
(72) Inventor: Yoo, Hyun Hwan, 443-743 Gyeonggi-do (KR); Kim, Gyu Suck, 443-743 Gyeonggi-do (KR); Hwang, Hyeon Seok, 443-743 Gyeonggi-do (KR); Na, Yoo Sam, 443-743 Gyeonggi-do (KR); Kim, Yoo Hwan, 443-743 Gyeonggi-do (KR)
(74) Representative: Potter Clarkson LLP

(57) **Abstract**

The present invention relates to a signal processing apparatus and a system and a method for automatic gain control using the same. It is possible to improve operation characteristics of a receiver in a strong electric field or a weak electric field by providing a signal processing apparatus including: a frequency sweeping unit for outputting a signal (S) for sweeping each channel frequency within a certain interval through a receiver; a signal level detecting unit for detecting a signal level of each channel by reading a gain value set when sweeping each channel frequency from the receiver; and a take-over point (TOP) adjusting unit for changing a TOP value of the receiver according to the detected signal level of each channel, and a system and a method for automatic gain control using the same.

## Description

### CROSS-REFERENCE TO RELATED APPLICATIONS

This application claims the foreign priority benefit of Korean Patent Application Serial No. 10-2012-0058287, filed May 31, 2012 in the Korean Intellectual Property Office, the disclosure of which is hereby incorporated by reference in its entirety into this application.

### BACKGROUND OF THE INVENTION

### 1. Field of the Invention

The present invention relates to a signal processing apparatus and a system and a method for automatic gain control using the same, and more particularly, to a signal processing apparatus that can improve linearity and noise characteristics of a receiver in a weak electric field or a strong electric field, and a system and a method for automatic gain control using the same.

### 2. Description of the Related Art

In general, an electrical apparatus, which processes a signal, performs automatic gain control (AGC) to reduce intermodulation and prevent saturation occurring in an amplifier. Particularly, a receiver of a mobile communication system uses the automatic gain control to obtain a signal having a desired level from an input signal having an irregular level. That is, when an input signal level is higher than a reference value, the automatic gain control reduces a gain value to prevent the saturation of the signal, and when the input signal level is lower than the reference value, the automatic gain control increases the gain value to control the signal having a constant level to be output.

In relation to this, Korean Laid-open Patent Publication No. 10-2011-0068778 (hereinafter, related art document) discloses a method and an apparatus for automatic gain control that guarantee reliability of automatic gain control by performing the steps of low-noise amplifying a received signal using a first gain value, amplifying the low-noise amplified received signal using a second gain value, determining the first gain value by using a strength of the low-noise amplified received signal, and determining the second gain value by using the received signal amplified using the second gain value.

However, the method and the apparatus for automatic gain control of the related art document do not consider a channel environment of satellite broadcasting at all. Thus, there is a difficulty in receiving a signal transmitted from a satellite broadcasting station.

In the channel environment of the satellite broadcasting which outputs a broadband frequency signal (950MHz to 2150MHz), there is a large difference in strength between the signals according to the reception area and the weather. And, in recent times, according to the conversion into high-definition digital broadcasting, required specifications of the receiver are gradually enhanced. Thus, the satellite broadcasting station transmits stronger signals than the existing channel. For these reasons, the interference between a specific channel (hereinafter, specific channel) users want to receive and a channel (hereinafter, adjacent channel) adjacent to the specific channel are getting worse.

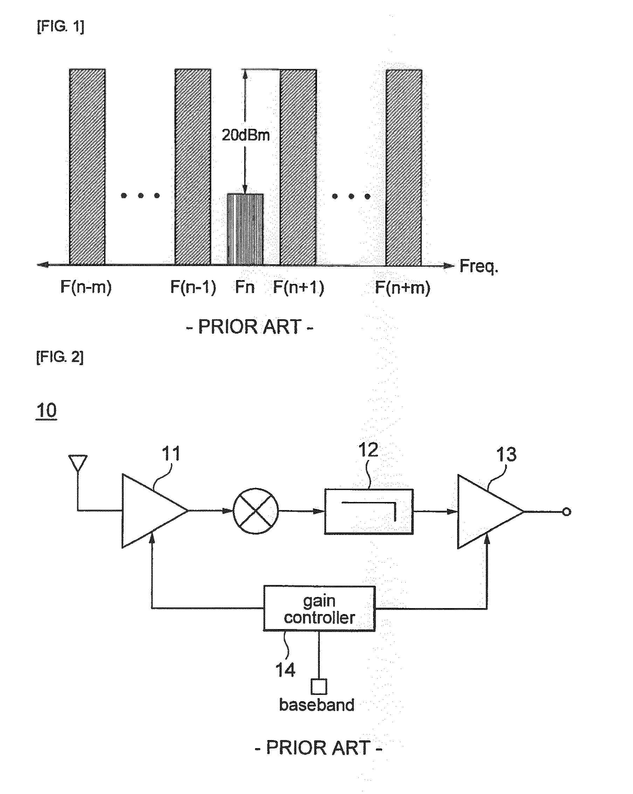

FIG. 1 is a view showing a signal level of each channel in a satellite broadcasting frequency band. As shown in FIG. 1, in the channel environment of the satellite broadcasting, the adjacent channel having a signal level higher than that of the specific channel by 20dBm may be received. In this case, it is impossible to prevent deterioration of linearity and noise characteristics of the receiver only using the method and the apparatus for automatic gain control disclosed in the above related art document.

The automatic gain control systems can be largely classified into an external automatic gain control system (hereinafter, external AGC system) and an internal automatic gain control system (hereinafter, internal AGC system).

FIG. 2 is a block diagram of the external AGC system. The external AGC system is the most commonly used AGC system. Referring to FIG. 2, the external AGC system detects a final output signal level of the receiver by a demodulator (not shown) of a base-band stage and sets gain values of an RF amplifier (RFVGA) 11 and an IF amplifier (IFVGA) 13 through a gain controller 14 according to the detected final output signal level.

In the external AGC system, since the gain value is set only by a signal after a band pass filter 12, that is, the signal level of the specific channel, the linearity characteristics of the receiver may be deteriorated when the adjacent channel having a higher signal level than the specific channel enters in a strong electric field (area with strong signals) as in FIG. 1.

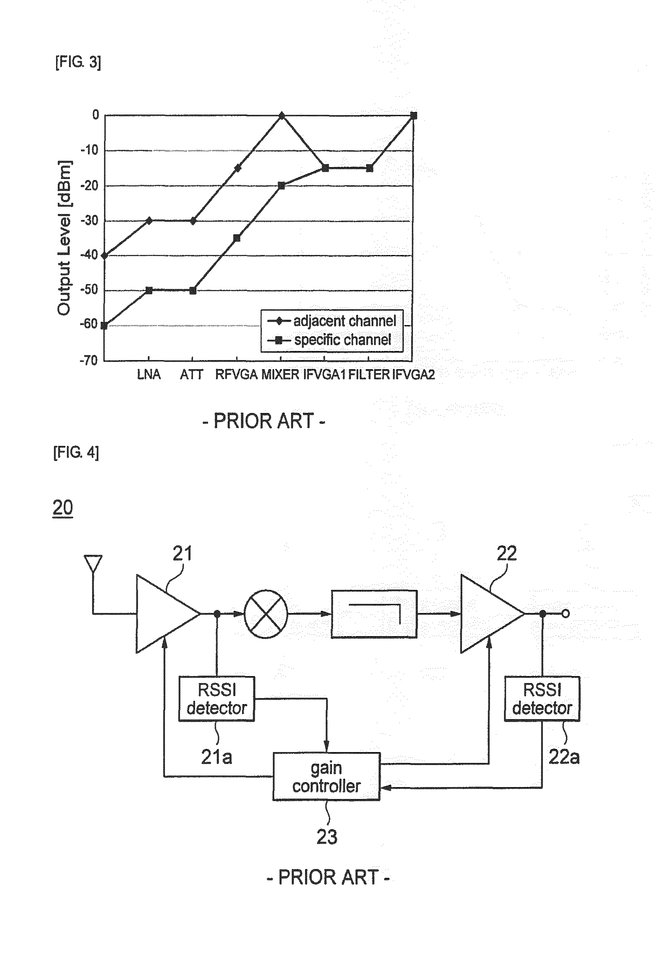

FIG. 3 is a signal level diagram of each block stage of the external AGC system. Here, a vertical axis represents an output signal level (dBm), and a horizontal axis represents each block stage of the external AGC system. For reference, a low-nose amplifier (LNA) and an attenuator (ATT) are further provided at a front end of a mixer of FIG. 1 and the IF amplifier (IFVGA) is further provided at a front end of the band pass filter.

Referring to FIG. 3, the signal level of the specific channel is -60dBm corresponding to the strong electric field, and the signal level of the adjacent channel is -40dBm. The signal level of the adjacent channel is higher than that of the specific channel by more than 20dBm.

In this case, as described above, in the external AGC system, since the gain value is set by the signal level of the specific channel passing through the band pass filter 12, the adjacent channel signal is amplified with the same gain value as the specific channel signal. Due to this, finally, as in FIG. 3, before and behind the mixer, the adjacent channel signal deviates from an ideal gain control region and thus the linearity characteristics of the receiver are deteriorated.

FIG. 4 is a block diagram of the internal AGC system. Referring to FIG. 4, the internal AGC system includes received signal strength indicator (RSSI) detectors 21a and 22 which are respectively disposed in output terminals of an RF amplifier 21 and an IF amplifier 22 inside the receiver to detect a signal level of each amplifier and set a gain value of each amplifier through a gain controller 23 according to the detected signal level.

Like this, in the internal AGC system, since the gain value of each amplifier is set according to the signal level of each amplifier detected through the RSSI detector 21a and 22a, unlike the external AGC system, there is no problem of the deterioration of the linearity characteristics of the receiver due to the adjacent channel. However, since an automatic gain control method in the internal AGC system sets the gain value according to the signal level of the channel existing in the entire frequency band, in a weak electric field, the noise characteristics of the receiver may be deteriorated when the adjacent channel having a higher signal level than the specific channel enters as in FIG. 1.

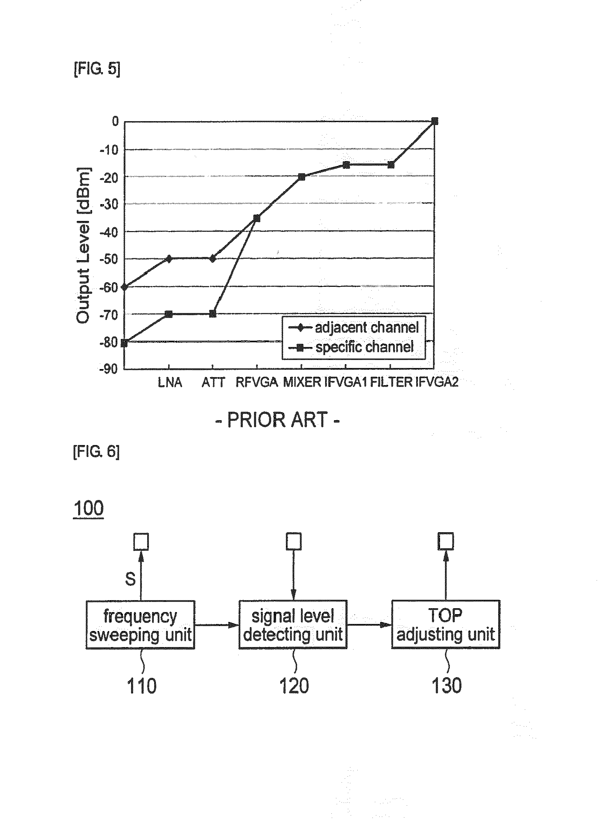

FIG. 5 is a signal level diagram of each block stage of the internal AGC system. Here, a vertical axis represents an output signal level (dBm), and a horizontal axis represents each block stage of the internal AGC system.

Referring to FIG. 5, the signal level of the specific channel is -80dBm corresponding to the weak electric field, and the signal level of the adjacent channel is -60dBm. The signal level of the adjacent channel is higher than that of the specific channel by more than 20dBm.

In this case, as described above, in the internal AGC system, since the gain value is set by the signal level of the channel existing in the entire frequency band, when the signal level of the specific channel is lowered below a minimum level that can be detected by the RSSI detector 21a and 22a, the gain value is set by the adjacent channel signal, not by the specific channel signal. Due to this, finally, as in FIG. 5, the noise characteristics of the receiver are deteriorated.

### [Related Art Document]

### [Patent Document]

Patent Document 1: Korean Laid-open Patent Publication No. 10-2011-0068778

### SUMMARY OF THE INVENTION

The present invention has been invented in order to overcome the above-described problems and it is, therefore, an object of the present invention to provide a signal processing apparatus that can improve linearity and noise characteristics of a receiver although there is a large difference in signal level between a specific channel and an adjacent channel in a strong electric field or a weak electric field, and a system and a method for automatic gain control using the same.

In accordance with one aspect of the present invention to achieve the object, there is provided a signal processing apparatus including: a frequency sweeping unit for outputting a signal (S) for sweeping each channel frequency within a certain interval through a receiver; a signal level detecting unit for detecting a signal level of each channel by reading a gain value set when sweeping each channel frequency from the receiver; and a take-over point (TOP) adjusting unit for changing a TOP value of the receiver according to the detected signal level of each channel.

Further, a width of each channel frequency within the certain interval, which is swept by the frequency sweeping unit, is set to an arbitrary value.

Further, the TOP adjusting unit changes the TOP value to a minimum level within the range in which the signal can be detected when a difference in signal level between a specific channel and an adjacent channel among the signal levels of the channels detected by the signal level detecting unit is greater than a first threshold and the signal level of the specific channel is greater than a second threshold.

Further, the TOP adjusting unit changes the TOP value to a maximum level within the range in which linearity of the receiver is maintained when the difference in signal level between the specific channel and the adjacent channel among the signal levels of the channels detected by the signal level detecting unit is greater than the first threshold and the signal level of the specific channel is less than a third threshold.

Further, the signal processing apparatus and the receiver transmit the signal to each other through any one communication interface line of a universal asynchronous receiver/transmitter (UART), a serial peripheral interface (SPI), and an inter-integrated circuit (I2C).

Further, the certain interval is a satellite broadcasting frequency band.

In accordance with another aspect of the present invention to achieve the object, there is provided a system for automatic gain control including: a first amplifier for amplifying a radio frequency (RF) signal received from an antenna; a mixer for down-converting a frequency of the amplified signal; a band pass filter for selecting and passing a specific channel frequency among the down-converted signals; a second amplifier for amplifying the specific channel signal passing through the band pass filter to output the amplified signal to the outside; a gain controller for setting gain values of the first and second amplifiers according to a signal applied from the outside; and a signal processing apparatus for changing a TOP value of the gain controller according to signal levels of a specific channel and an adjacent channel.

Further, the system for automatic gain control further includes a local oscillator for generating a predetermined oscillation frequency source according to an external control voltage Vc to output the oscillation frequency source to the mixer; and a phase locked loop (PLL) for outputting the control voltage Vc to the local oscillator, wherein the control voltage Vc of the PLL varies according to a signal S applied from the signal processing apparatus.

Further, the signal processing apparatus includes a frequency sweeping unit for outputting the signal S for varying the control voltage Vc of the PLL to sweep each channel frequency within a certain interval through the first amplifier, the mixer, the band pass filter, and the second amplifier; a signal level detecting unit for detecting the signal level of each channel by reading the gain value of each amplifier set when sweeping each channel frequency from the gain controller; and a TOP adjusting unit for changing the TOP value of the gain controller according to the detected signal level of each channel.

Further, the TOP adjusting unit changes the TOP value to a minimum level within the range in which the signal can be detected when a difference in the signal level between the specific channel and the adjacent channel among the signal levels of the channels detected by the signal level detecting unit is greater than a first threshold TH1 and the signal level of the specific channel is greater than a second threshold TH2.

Further, the TOP adjusting unit maintains the TOP value to an existing value when the difference in signal level between the specific channel and the adjacent channel among the signal levels of the channels detected by the signal level detecting unit is less than the first threshold TH1 or the signal level of the specific channel is less than the second threshold TH2.

Further, the mixer outputs an intermediate frequency (IF) band signal by down-converting the frequency of the amplified signal.

In accordance with another aspect of the present invention to achieve the object, there is provided a system for automatic gain control including: a first amplifier for amplifying an RF signal received from an antenna; a mixer for down-converting a frequency of the amplified signal; a band pass filter for selecting and passing a specific channel frequency among the down-converted signals; a second amplifier for amplifying the specific channel signal passing through the band pass filter to output the amplified signal to the outside; a gain controller for adjusting a gain value of the first amplifier according to an RSSI value of the first amplifier and setting a gain value of the second amplifier according to an RSSI value of the second amplifier; and a signal processing apparatus for changing a TOP value of the gain controller according to signal levels of a specific channel and an adjacent channel.

Further, the system for automatic gain control further includes a local oscillator for generating a predetermined oscillation frequency source according to a control voltage to output the oscillation frequency source to the mixer; and a PLL for outputting the control voltage Vc to the local oscillator, wherein the control voltage Vc of the PLL varies according to a signal S applied from the signal processing apparatus.

Further, the signal processing apparatus includes a frequency sweeping unit for outputting a control signal of varying the control voltage Vc of the PLL to sweep each channel frequency within a certain interval through the first amplifier, the mixer, the band pass filter, and the second amplifier; a signal level detecting unit for detecting the signal level of each channel by reading the gain value of each amplifier set when sweeping each channel frequency from the gain controller; and a TOP adjusting unit for changing the TOP value of the gain controller according to the detected signal level of each channel.

Further, the TOP adjusting unit changes the TOP value to a maximum level within the range in which linearity of a receiver is maintained when a difference in the signal level between the specific channel and the adjacent channel among the signal levels of the channels detected by the signal level detecting unit is greater than a first threshold TH1 and the signal level of the specific channel is less than a third threshold TH3.

Further, the TOP adjusting unit maintains the TOP value to an existing value when the difference in the signal level between the specific channel and the adjacent channel among the signal levels of the channels detected by the signal level detecting unit is less than the first threshold TH1 or the signal level of the specific channel exceeds the third threshold TH3.

In accordance with another aspect of the present invention to achieve the object, there is provided a method for automatic gain control of a system for automatic gain control including a first amplifier, a mixer, a band pass filter, a second amplifier, a gain controller, and a signal processing apparatus, wherein the gain controller sets gain values of the first and second amplifiers according to a signal applied from the outside, including: (a) detecting the highest signal level (hereinafter, Max. Level value) among the signal levels of channels within a certain interval; (b) detecting a signal level (hereinafter, Cur. Level value) of a specific channel; (c) determining whether a difference between the Cur. Level value and the Max. Level value is greater than a first threshold TH1; (d) determining whether the Cur. Level value is greater than a second threshold TH2 when the difference between the Cur. Level value and the Max. Level value is greater than the first threshold TH1 in the step (c); and (e) changing a TOP value to a minimum level within the range in which the signal can be detected when the Cur. Level value is greater than the second threshold TH2.

Further, the step (a) is performed through (a1) initializing the Max. Level value to an arbitrary value; (a2) sweeping an nth channel frequency among the channels within the certain interval; (a3) detecting a signal level (hereinafter, n. Level value) of the nth channel; (a4) determining whether the n. Level value exceeds the Max. Level value; (a5) changing the Max. Level value to the n. Level value when the n. Level value exceeds the Max. Level value in the step (a4); and (a6) determining whether the nth channel and an mth channel are equal to each other.

Further, when the n. Level value is less than the Max. Level value in the step (a4), the flow branches to the step (a6).

Further, when the nth channel and the mth channel are equal to each other in the step (a6), the process of detecting the Max. Level value is finished, and when the nth channel and the mth channel are not equal to each other, the flow branches to the step (a2) under the condition of n=n+1.

Further, when the difference between the Cur. Level value and the Max. Level value is less than the first threshold TH1 in the step (c) or when the Cur. Level value is less than the second threshold TH2 in the step (d), the TOP value is maintained to an existing value.

In accordance with another aspect of the present invention to achieve the object, there is provided a method for automatic gain control of a system for automatic gain control including a first amplifier, a mixer, a band pass filter, a second amplifier, a gain controller, and a signal processing apparatus, wherein the gain controller adjusts a gain value of the first amplifier according to an RSSI value of the first amplifier and adjusts a gain value of the second amplifier according to an RSSI value of the second amplifier, including: (a) detecting the highest signal level (hereinafter, Max. Level value) among the signal levels of channels within a certain interval; (b) detecting a signal level (hereinafter, Cur. Level value) of a specific channel; (c) determining whether a difference between the Cur. Level value and the Max. Level value is greater than a first threshold TH1; (d) determining whether the Cur. Level value is less than a third threshold TH3 when the difference between the Cur. Level value and the Max. Level value is greater than the first threshold TH1 in the step (c); and (e) changing a TOP value to a maximum level within the range in which linearity characteristics of a receiver are maintained when the Cur. Level value is less than the third threshold TH3.

Further, when the difference between the Cur. Level value and the Max. Level value is less than the first threshold TH1 in the step (c) or when the Cur. Level value exceeds the third threshold TH3 in the step (d), the TOP value is maintained to an existing value.

### BRIEF DESCRIPTION OF THE DRAWINGS

These and/or other aspects and advantages of the present general inventive concept will become apparent and more readily appreciated from the following description of the embodiments, taken in conjunction with the accompanying drawings of which:

FIG. 1 is a view showing a signal level of each channel in a satellite broadcasting frequency band;

FIG. 2 is a block diagram of an external AGC system;

FIG. 3 is a signal level diagram of each block stage of the external AGC system;

FIG. 4 is a block diagram of an internal AGC system;

FIG. 5 is a signal level diagram of each component of the internal AGC system;

FIG. 6 is a configuration block diagram of a signal processing apparatus in accordance with the present invention;

FIG. 7 is a block diagram of a first automatic gain control system;

FIG. 8 is a signal level graph of each channel appearing when changing a TOP value in the first automatic gain control system;

FIG. 9 is a graph showing the TOP value changed in the first automatic gain control system;

FIG. 10 is a configuration block diagram of a second automatic gain control system;

FIG. 11 is a detailed diagram of a gain controller;

FIG. 12 is a signal level graph of each channel appearing when changing a TOP value in the second automatic gain control system;

FIG. 13 is a graph showing the TOP value changed in the second automatic gain control system;

FIG. 14 is a flowchart of a first automatic gain control method;

FIG. 15 is a flowchart of a second automatic gain control method; and

FIG. 16 is a flowchart of a method of detecting a Max. Level value.

### DETAILED DESCRIPTION OF THE PREFERABLE EMBODIMENTS

Advantages and features of the present invention and methods of accomplishing the same will be apparent by referring to embodiments described below in detail in connection with the accompanying drawings. However, the present invention is not limited to the embodiments disclosed below and may be implemented in various different forms. The exemplary embodiments are provided only for completing the disclosure of the present invention and for fully representing the scope of the present invention to those skilled in the art. Like reference numerals refer to like elements throughout the specification.

Terms used herein are provided to explain embodiments, not limiting the present invention. Throughout this specification, the singular form includes the plural form unless the context clearly indicates otherwise. When terms "comprises" and/or "comprising" used herein do not preclude existence and addition of another component, step, operation and/or device, in addition to the above-mentioned component, step, operation and/or device.

Hereinafter, configuration and operational effect of the present invention will be described in detail with reference to the accompanying drawings.

FIG. 6 is a configuration block diagram of a signal processing apparatus in accordance with the present invention.

Referring to FIG. 6, the signal processing apparatus 100 in accordance with the present invention may include a frequency sweeping unit 110, a signal level detecting unit 120, and a TOP adjusting unit 130.

The frequency sweeping unit 110 applies a signal S to a receiver (not shown) so that each channel frequency within a certain interval is sequentially swept through the receiver.

Here, the receiver is a receiving apparatus, which consists of an amplifier, a filter, a mixer, and so on and amplifies and filters a signal input from an antenna to output the signal to the outside (for example, demodulator), and can be used in all devices that receive and process a radio frequency signal, such as mobile communication devices or TV tuners. However, since the signal processing apparatus 100 in accordance with the present invention is aimed to improve operation characteristics of the receiver in a satellite broadcasting environment with severe signal interference between channels, it is preferred that the receiver is a satellite broadcasting receiver, and the certain interval also may be a satellite broadcasting frequency band interval.

Specifically, the signal S applied to the receiver by the frequency sweeping unit 110 varies an oscillation frequency source provided to a mixer (not shown) inside the receiver. Like this, as the oscillation frequency source provided to the mixer is varied by the signal S, each channel frequency within the certain interval can be sequentially swept through the receiver.

At this time, a width of each channel frequency within the certain interval, which is sequentially swept by the frequency sweeping unit 110, may be set to an arbitrary value. This is because the width of each channel frequency in satellite broadcasting is not uniformly determined, unlike terrestrial broadcasting. For example, the width of each channel frequency, which is swept through the receiver, may be 40MHz. Accordingly, the oscillation frequency source provided to the mixer may vary to 1920MHz, 1960MHz, 2000MHz, 2040MHz, and 2080MHz.

When each channel frequency within the certain interval is sequentially swept by the frequency sweeping unit 110, the signal level detecting unit 120 detects a signal level of each channel within the certain interval by reading a gain value set when sweeping each channel frequency from the receiver.

The process of detecting the signal level of each channel by the signal level detecting unit 120 will be described in detail in the following automatic gain control system using the signal processing apparatus 100 in accordance with the present invention.

When the signal level of each channel within the certain interval is detected by the signal level detecting unit 120, based on this, a take-over point (TOP) value of the receiver is changed according to the signal levels of a specific channel (hereinafter, specific channel) users want to receive among the channels within the certain interval and a channel (hereinafter, adjacent channel) adjacent to the specific channel.

Specifically, when a difference in the signal level between the specific channel and the adjacent channel is greater than a first threshold and the signal level of the specific channel is greater than a second threshold, the TOP adjusting unit 130 changes the TOP value to a minimum level within the range in which the signal can be detected.

And, when the difference in the signal level between the specific channel and the adjacent channel is greater than the first threshold and the signal level of the specific channel is less than a third threshold, the TOP adjusting unit 130 changes the TOP value to a maximum level within the range in which linearity characteristics of the receiver are maintained. The meanings of the first to third thresholds will be described in the following automatic gain control system using the signal processing apparatus 100 in accordance with the present invention.

Meanwhile, a communication interface line between the signal processing apparatus and the receiver may be any one of a universal asynchronous receiver/transmitter (UART), a serial peripheral interface (SPI), and an inter-integrated circuit (I2C).

Now, a first automatic gain control system using the signal processing apparatus in accordance with the present invention will be described.

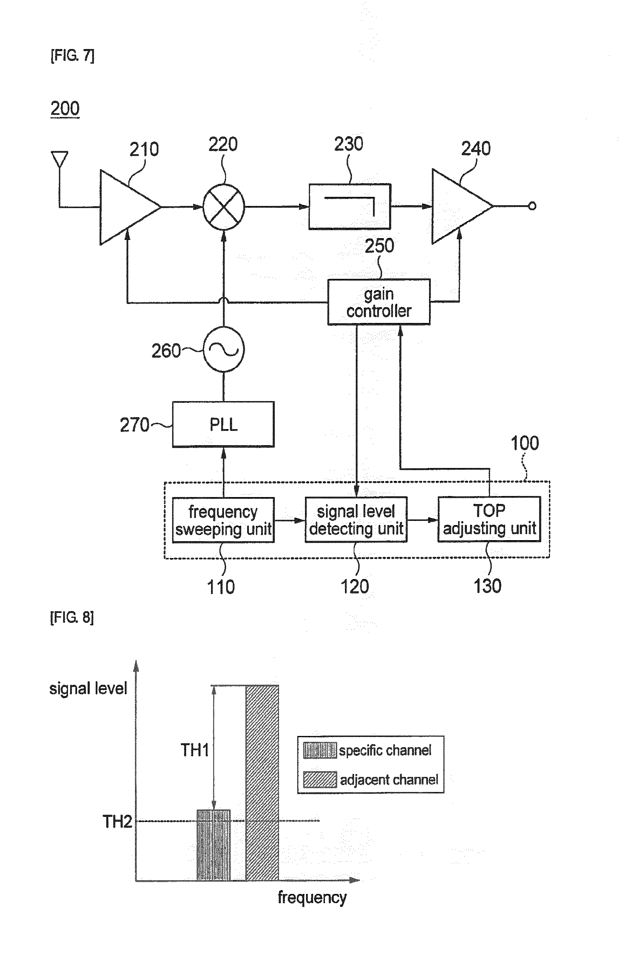

FIG. 7 is a block diagram of the first automatic gain control system.

Referring to FIG. 7, the first automatic gain control system 200 may include a first amplifier 210, a mixer 220, a band pass filter 230, a second amplifier 240, a gain controller 250, and a signal processing apparatus 100. In addition, the first automatic gain control system 200 may further include a local oscillator 260 and a phase locked loop (PLL) 270.

The first amplifier 210 amplifies a radio frequency (RF) signal received from an antenna. Since the first automatic gain control system 200 using the signal processing apparatus 100 in accordance with the present invention is aimed to improve operation characteristics of a receiver in a satellite broadcasting environment, a frequency band of the RF signal may be 950MHz to 2150MHz.

The first amplifiers 210 may be connected in multiple stages, and some of them may consist of a low-noise amplifier (LNA) to reduce a noise figure of the entire receiver. Further, an attenuator may be further provided at a front end or a rear end of the first amplifier 210 to suppress saturation of the signal and maintain stable receiving performance.

The mixer 220 down-converts a frequency of the RF signal amplified by the first amplifier 210. At this time, the signal down-converted by the mixer 220 may be an intermediate frequency (IF) signal.

The local oscillator 260 generates a predetermined oscillation frequency source according to an external control voltage Vc to output the oscillation frequency source to the mixer 220, and the PLL 270 outputs the control voltage Vc to the local oscillator 260. That is, the local oscillator 260 generates the oscillation frequency source (for example, 1920MHz, 1960MHz, 2000MHz, 2040MHz, 2080MHz) corresponding to the size of the control voltage Vc output from the PLL 270 to provide the oscillation frequency source to the mixer 220.

The band pass filter 230 selects and passes a specific channel frequency among the signals down-converted by the mixer 220.

The specific channel signal passing through the band pass filter 230 is amplified by the second amplifier 240 to be output to the outside (for example, demodulator). Since a frequency band of the signal down-converted by the mixer 220 may be an IF band, the second amplifier 240 may be an IF amplifier. Further, the second amplifiers 240 may be connected in multiple stages like the first amplifier 210, and some of them may be positioned at a front end of the band pass filter 230.

The gain controller 250 sets gain values of the first and second amplifiers 210 and 240. The signal levels output from the first and second amplifiers 210 and 240 are determined, respectively. Accordingly, when an input signal level is higher than a predetermined output signal level, the gain value is set low, and when the input signal level is lower than the predetermined output signal level, the gain value is set high.

The gain controller 250 in the first automatic gain control system 200 sets the gain values of the first and second amplifiers according to a signal applied from the outside. Here, the signal applied from the outside means a bit signal output from a demodulator (not shown) which is positioned outside the receiver to convert an analog signal output from the second amplifier 240 into a digital signal. Therefore, the first automatic gain control system 200 in accordance with the present invention may be an external automatic gain control system (hereinafter, external AGC system) which automatically controls the gain values of the first and second amplifiers according to the finally output signal level.

The signal processing apparatus 100 changes a TOP value of the gain controller 250 according to the signal levels of a specific channel and an adjacent channel.

The signal processing apparatus 100 may include a frequency sweeping unit 110, a signal level detecting unit 120, and a TOP adjusting unit 130.

The frequency sweeping unit 110 applies a signal S for varying the control voltage Vc of the PLL 270 to sweep each channel frequency within a certain interval through the first amplifier 210, the mixer 220, the band pass filter 230, and the second amplifier 240.

That is, the size of the control voltage Vc of the PLL 270 is varied by the signal S applied from the frequency sweeping unit 110, and the local oscillator 260 sequentially generates the oscillation frequency source (for example, 1920MHz, 1960MHz, 2000MHz, 2040MHz, 2080MHz) corresponding to the size of the varied control voltage Vc to provide the oscillation frequency source to the mixer 220. The signal received through the antenna is mixed with each oscillation frequency source (for example, 1920MHz, 1960MHz, 2000MHz, 2040MHz, 2080MHz) by the mixer 220 to be down-converted, and the down-converted signal passes through the band pass filter 230 and the second amplifier 240 so that each channel frequency within the certain interval is swept.

The signal level detecting unit 120 detects the signal level of each channel by reading the gain value of each amplifier set when sweeping each channel frequency from the gain controller 250.

In the external AGC system, since the gain value of each amplifier is set by the final output level and the final output level is preset to a certain value, it is possible to indirectly know the signal level of each channel by reading the gain value set when sweeping each channel frequency from the gain controller 250 through the bit signal of the demodulator (not shown).

The TOP adjusting unit 130 changes the TOP value of the gain controller 250 according to the detected signal level of each channel.

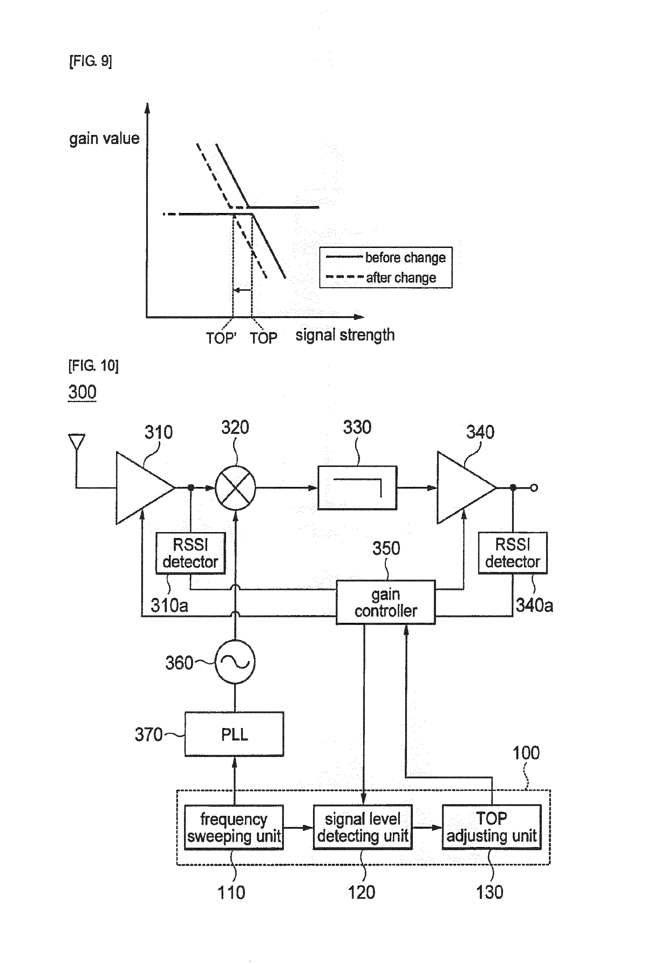

FIG. 8 is a signal level graph of each channel appearing when changing the TOP value in the first automatic gain control system, and FIG. 9 is a graph showing the TOP value changed in the first automatic gain control system.

When a difference in the signal level between the specific channel and the adjacent channel is greater than a first threshold TH1 among the signal levels of the channels detected by the signal level detecting unit 120 and the signal level of the specific channel is greater than a second threshold TH2 as in FIG. 8, the TOP adjusting unit 130 changes the TOP value to a minimum level TOP' within the range in which the signal can be detected as in FIG. 9.

In the external AGC system, when the adjacent channel having a higher signal level than the specific channel enters in a strong electric field, since linearity characteristics of the receiver become an issue, the first threshold TH1 means the lowest threshold level in which the characteristics of the receiver may be deteriorated due to the difference in the signal level between the specific level and the adjacent channel, and the second threshold TH2 means the lowest level in the signal range classified as the strong electric field.

When the first threshold TH1 is very low, overload of the system may occur due to an increase in the amount of calculation. On the contrary, when the first threshold TH1 is too high, since operation reliability of the system cannot be secured, it is preferred that the first threshold TH1 is set within an appropriate range. Generally, the first threshold TH1 may be 20dBm, and the second threshold TH2 may be -60dBm.

Like this, the first automatic gain control system 200, which is an external AGC system, can maintain the linearity characteristics of the receiver by changing the TOP value to the minimum level within the range in which the signal can be detected when the adjacent channel having a higher signal level enters in the strong electric field.

Meanwhile, although the specific channel corresponds to the strong electric field, in other words, although greater than the second threshold TH2, when the difference in the signal level between the specific channel and the adjacent channel is less than the first threshold TH1, the TOP adjusting unit 130 maintains the TOP value to an existing value since there is no concern about the deterioration of the linearity characteristics of the receiver due to the signal level of the adjacent channel.

And, although the difference in the signal level between the specific channel and the adjacent channel is greater than the first threshold TH1, when the signal level of the specific channel is less than the second threshold TH2, since there is no concern about the deterioration of the linearity characteristics of the receiver, the TOP adjusting unit 130 maintains the TOP value to the existing value.

Now, a second automatic gain control system using the signal processing apparatus in accordance with the present invention will be described.

FIG. 10 is a configuration block diagram of the second automatic gain control system.

Referring to FIG. 10, the second automatic gain control system 300 may include a first amplifier 310, a mixer 320, a band pass filter 330, a second amplifier 340, a gain controller 350, and a signal processing apparatus 100. In addition, the second automatic gain control system 300 may further include a local oscillator 360 and a PLL 370. Here, since the first amplifier 310, the mixer 320, the band pass filter 330, the second amplifier 340, the local oscillator 360, and the PLL 370 are described above, detailed descriptions thereof will be omitted.

The gain controller 350 sets gain values of the first and second amplifiers 310 and 340. The signal levels output from the first and second amplifiers 310 and 340 are determined, respectively. Accordingly, when an input signal level is higher than a predetermined output signal level, the gain value is set low, and when the input signal level is lower than the output signal level, the gain value is set high.

The gain controller 350 in the second automatic gain control system 300 adjusts the gain value of the first amplifier 310 according to a received signal strength indication (RSSI) value of the signal output from the first amplifier 310 and adjusts the gain value of the second amplifier 340 according to the RSSI value of the signal output from the second amplifier 340. Therefore, the second automatic gain control system 300 may be an internal automatic gain control system (hereinafter, internal AGC system) that automatically controls the gain value of each amplifier according to the signal level of each amplifier.

In the second automatic gain control system 300, a first RSSI detector 310a may be further connected to an output terminal side of the first amplifier 310 to detect the RSSI value of the first amplifier 310. Similarly, a second RSSI detector 340a may be further connected to an output terminal side of the second amplifier 340 to detect the RSSI value of the second amplifier 340.

The signal processing apparatus 100 changes a TOP value of the gain controller 350 according to signal levels of a specific channel and an adjacent channel.

The signal processing apparatus 100 may include a frequency sweeping unit 110, a signal level detecting unit 120, and a TOP adjusting unit 130.

The frequency sweeping unit 110 applies a signal S for varying a control voltage Vc of the PLL 370 to sweep each channel frequency within a certain interval through the first amplifier 310, the mixer 320, the band pass filter 330, and the second amplifier 340.

The process of sweeping each channel frequency within the certain interval by the frequency sweeping unit 110 is the same as that of the above-described first automatic gain control system 200.

The signal level detecting unit 120 detects the signal level of each channel by reading the gain value of each amplifier set when sweeping each channel frequency from the gain controller 350.

In the internal AGC system, the gain value of each amplifier 310 and 340 is controlled by the RSSI detector 310a and 340a at the output terminal of each amplifier, and an output level may be changed by the TOP adjusting unit 130.

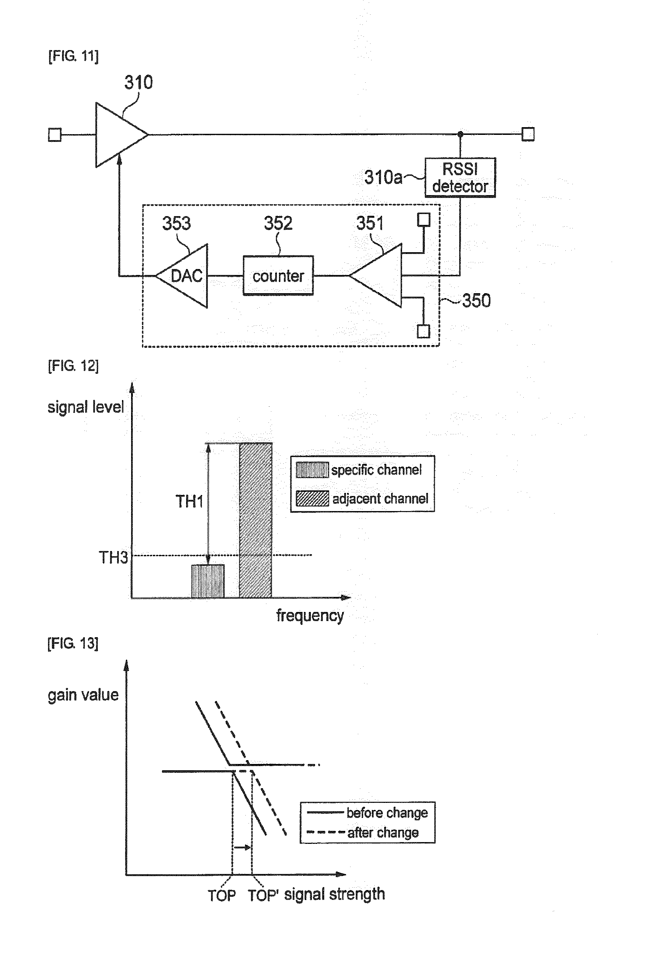

FIG. 11 is a detailed diagram of the gain controller. For example, the first amplifier 310 may convert an analog voltage output from the first RSSI detector 310a into a digital signal through a comparator 351 and a counter 352 and discretely control the gain value of the first amplifier 310 through the digital signal. Although not shown in the drawing, the second amplifier 340 also can discretely control the gain value in the same way.

The TOP adjusting unit 130 changes the TOP value of the gain controller 350 according to the detected signal level of each channel.

FIG. 12 is a signal level graph of each channel appearing when changing the TOP value in the second automatic gain control system, and FIG. 13 is a graph showing the TOP value changed in the second automatic gain control system.

When a difference in the signal level between the specific channel and the adjacent channel is greater than a first threshold TH1 among the signal levels of the channels detected by the signal level detecting unit 120 and the signal level of the specific channel is less than a third threshold TH3 as in FIG. 12, the TOP adjusting unit 130 changes the TOP value to a maximum level TOP' within the range in which linearity characteristics of a receiver are maintained as in FIG. 13.

In the internal AGC system, when the adjacent channel having a higher signal level than the specific channel enters in a weak electric field, since noise characteristics of the receiver become an issue, the first threshold TH1 means the lowest threshold level in which the characteristics of the receiver may be deteriorated due to the difference in the signal level between the specific level and the adjacent channel, and the third threshold TH3 means the highest level in the signal range classified as the weak electric field. Here, the first threshold TH1 may be 20dBm, and the third threshold TH3 may be -80dBm.

Like this, the second automatic gain control system 300, which is an internal AGC system, can maintain the noise characteristics of the receiver by changing the TOP value to the maximum level within the range in which the linearity characteristics of the receiver are maintained when the adjacent channel having a higher signal level enters in the weak electric field.

Meanwhile, although the specific channel corresponds to the weak electric field, in other words, although less than the third threshold TH3, when the difference in the signal level between the specific channel and the adjacent channel is less than the first threshold TH1, the TOP adjusting unit 130 maintains the TOP value to an existing value since there is no concern about the deterioration of the characteristics of the receiver due to the signal level of the adjacent channel.

And, although the difference in the signal level between the specific channel and the adjacent channel is greater than the first threshold TH1, when the signal level of the specific channel exceeds the third threshold TH3, since there is no concern about the deterioration of the noise characteristics of the receiver, the TOP adjusting unit 130 maintains the TOP value to the existing value.

Now, a first automatic gain control method using the signal processing apparatus in accordance with the present invention will be described. The first automatic gain control method using the signal processing apparatus in accordance with the present invention is performed in the above-described first automatic gain control system, that is, an external AGC system.

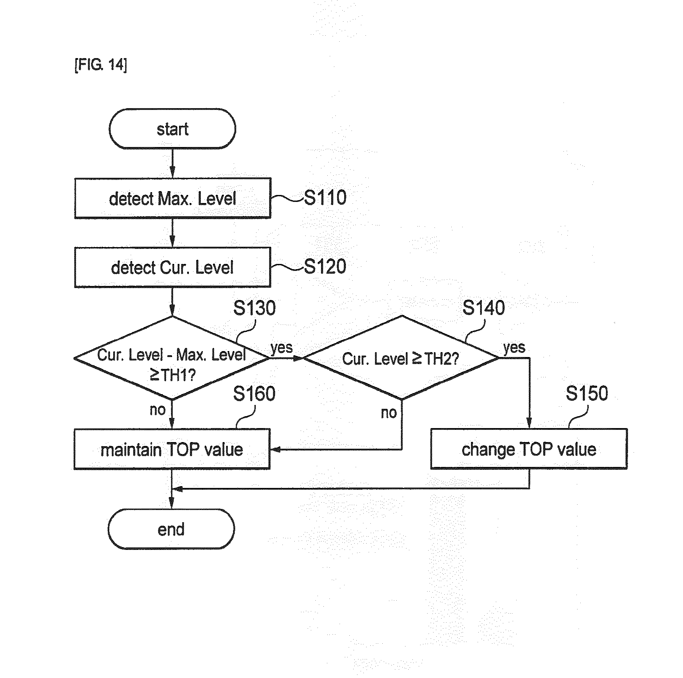

FIG. 14 is a flowchart of the first automatic gain control method.

Referring to FIG. 14, first, the first automatic gain control method performs the step of detecting the highest signal level (hereinafter, Max. Level value) among the signal levels of channels within a certain interval (S110). The method of detecting the Max. Level value will be described later.

When the Max. Level value is detected, the step of detecting the signal level (hereinafter, Cur. Level value) of a specific channel is performed (S120).

In the external AGC system, since a gain value of each amplifier is set by a final output level and the final output level is preset to a certain value, it is possible to indirectly know the signal level of each channel by reading the gain value set when sweeping each channel frequency from a gain controller 250 through a bit signal of a demodulator (not shown).

When the Cur. Level value is detected, the step of determining whether a difference between the Cur. Level value and the Max. Level value is greater than a first threshold TH1 is performed (S130). Here, the first threshold TH1 means the lowest threshold level in which characteristics of a receiver may be deteriorated due to a difference in the signal level between the specific channel and an adjacent channel.

When it is determined that the difference between the Cur. Level value and the Max. Level value is greater than the first threshold TH1 in the step S130, the step of determining whether the Cur. Level value is greater than a second threshold TH2 is performed (S140). Here, the second threshold TH2 means the lowest level in the signal range classified as a strong electric field.

When the Cur. Level value is greater than the second threshold TH2, the step of changing a TOP value to a minimum level within the range in which the signal can be detected is performed (S150).

Like this, according to the first automatic gain control method performed in the external AGC system, although the adjacent channel having a higher signal level enters in the strong electric field, it is possible to maintain linearity characteristics of the receiver by changing the TOP value to the minimum level within the range in which the signal can be detected.

Meanwhile, when the difference between the Cur. Level value and the Max. Level value is less than the first threshold TH1 in the step S130 or when the Cur. Level value is less than the second threshold TH2 in the step S140, the TOP value is maintained to an existing value.

Now, a second automatic gain control method using the signal processing apparatus in accordance with the present invention will be described. The second automatic gain control method using the signal processing apparatus in accordance with the present invention is performed in the above-described second automatic gain control system, that is, an internal AGC system.

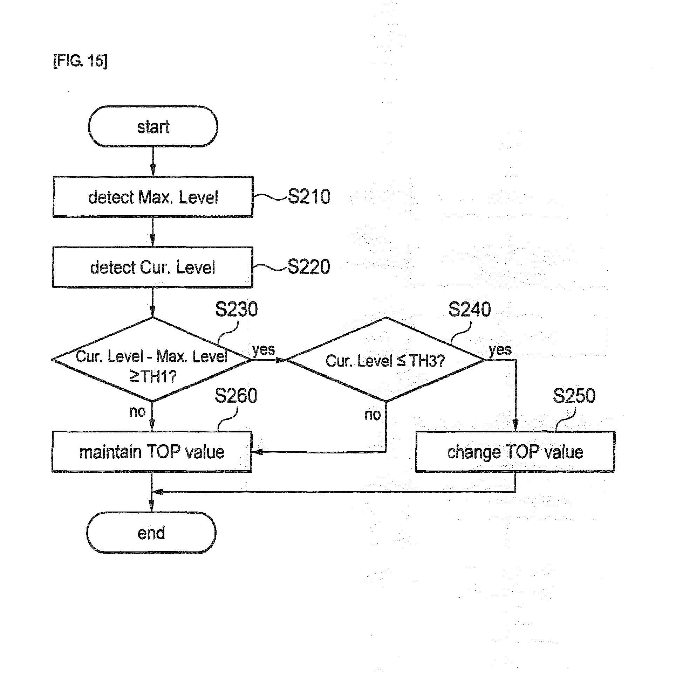

FIG. 15 is a flowchart of the second automatic gain control method.

Referring to FIG. 15, first, the second automatic gain control method performs the step of detecting a Max. Level value is performed (S210). The method of detecting the Max. Level value will be described later.

When the Max. Level value is detected, the step of detecting a Cur. Level value is performed (S220).

In the internal AGC system, since a gain value of each amplifier is set by an output level of each amplifier and the output level of each amplifier is preset to a certain value, it is possible to indirectly know the signal level of each channel by reading the gain value set when sweeping each channel frequency from the gain controller 250 through a bit signal of a demodulator (not shown).

When the Cur. Level value is detected, the step of determining whether a difference between the Cur. Level value and the Max. Level value is greater than a first threshold TH1 is performed (S230). Here, the first threshold TH1 means the lowest threshold level in which characteristics of a receiver can be deteriorated due to a difference in signal level between a specific channel and an adjacent channel.

When it is determined that the difference between the Cur. Level value and the Max. Level value is greater than the first threshold TH1 in the step S230, the step of determining whether the Cur. Level value is less than a third threshold TH3 is performed (S240). Here, the third threshold TH3 means the highest level in the signal range classified as a weak electric field.

When the Cur. Level value is less than the third threshold TH3, the step of changing a TOP value to a maximum level within the range in which linearity characteristics of the receiver are maintained is performed (S250).

Like this, according to the second automatic gain control method performed in the internal AGC system, although the adjacent channel having a higher signal level enters in the weak electric field, it is possible to maintain noise characteristics of the receiver by changing the TOP value to the maximum level within the range in which the linearity characteristics of the receiver are maintained.

Meanwhile, when the difference between the Cur. Level value and the Max. Level value is less than the first threshold TH1 in the step S230 or when the Cur. Level value exceeds the third threshold TH3 in the step S240, the TOP value is maintained to an existing value.

Now, the method of detecting the Max. Level value of the steps S110 and S120 will be described.

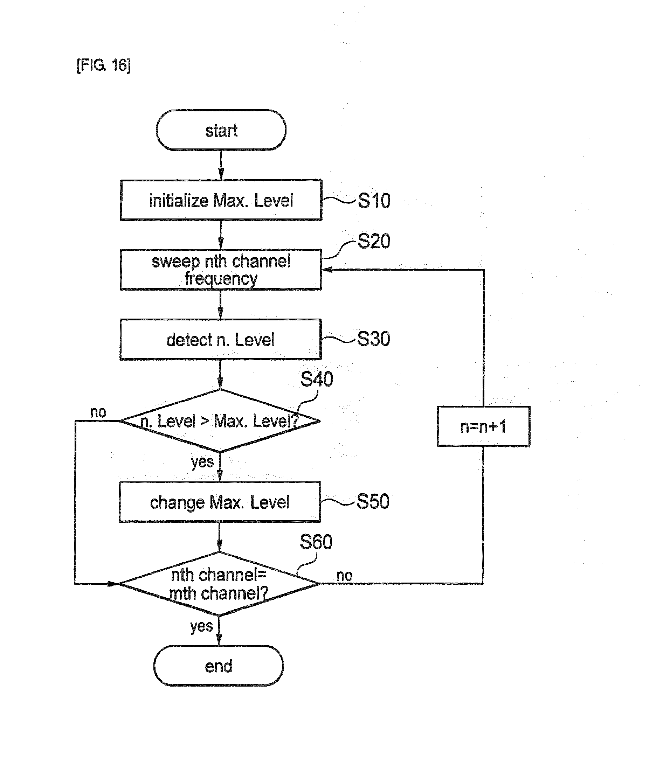

FIG. 16 is a flowchart of the method of detecting the Max. Level value. Referring to FIG. 16, first, the method of detecting the Max. Level value performs the step of initializing the Max. Level value to an arbitrary value (S10). Here, the arbitrary value becomes an arbitrary reference value for comparison with the signal level of each channel detected in the following step.

Next, the step of sweeping an nth channel frequency among the channels within a certain interval is performed (S20).

The nth channel means a channel corresponding to the lowest frequency of the channel frequencies to be swept. Therefore, the smaller the n is, a wider range of frequencies can be swept. However, when the n is too small, overload of the system may occur due to an increase in the amount of calculation.

Next, the step of detecting a signal level (hereinafter, n. Level value) of the nth channel is performed (S30). This step can be performed by the same method as the method of detecting the Cur. Level value in the step S120 or S220.

Next, the step of determining whether the n. Level value exceeds the Max. Level value is performed (S40). In order to detect the highest signal level among the channels within the certain interval, it is determined whether the detected signal level of each channel is greater than the Max. Level value initialized to the arbitrary value in the step S10.

When the n. Level value exceeds the Max. Level value in the step S40, the step of changing the Max. Level value to the n. Level value is performed (S50).

Like this, when the Max. Level value initialized to the arbitrary value in the step S10 is changed to the n. Level value higher than the arbitrary value, the changed Max. Level value becomes a reference value compared with the signal level of the channel which is to be swept later.

Next, the step of determining whether the nth channel and an mth channel are equal to each other is performed (S60).

The mth channel means a channel corresponding to the highest frequency among the channel frequencies to be swept. Therefore, the larger the m is, a wider range of frequencies can be swept. However, when the m is too large, the overload of the system may occur due to an increase in the amount of calculation.

Next, when the nth channel and the mth channel are equal to each other in the step S60, the process of detecting the Max. Level value is finished. And, when the nth channel and the mth channel are not equal to each other, the flow branches to the step S20 under the condition of n=n+1 to sweep the next channel frequency. Accordingly, all the channel frequencies from the nth channel frequency to the mth channel frequency, which are to be swept, can be sequentially swept.

Meanwhile, when the n. Level value is less than the Max. Level value in the step S40, the flow branches to the step S60 without changing the Max. Level value to finish the process of detecting the Max. Level value or to sweep the next channel frequency.

According to the signal processing apparatus and the system and the method for automatic gain control in accordance with the present invention, in the automatic gain control of an external AGC system, it is possible to amplify a signal while maintaining linearity characteristics of a receiver even though an adjacent channel having a higher signal level than a specific channel enters in a strong electric field.

And, in the automatic gain control of an internal AGC system, it is possible to amplify a signal while maintaining noise characteristics of a receiver even though an adjacent channel having a higher signal level than a specific channel enters in a weak electric field.

The foregoing description illustrates the present invention. Additionally, the foregoing description shows and explains only the preferred embodiments of the present invention, but it is to be understood that the present invention is capable of use in various other combinations, modifications, and environments and is capable of changes and modifications within the scope of the inventive concept as expressed herein, commensurate with the above teachings and/or the skill or knowledge of the related art. The embodiments described hereinabove are further intended to explain best modes known of practicing the invention and to enable others skilled in the art to utilize the invention in such, or other, embodiments and with the various modifications required by the particular applications or uses of the invention. Accordingly, the description is not intended to limit the invention to the form disclosed herein. Also, it is intended that the appended claims be construed to include alternative embodiments.

## Claims

1. A signal processing apparatus comprising:
a frequency sweeping unit for outputting a signal (S) for sweeping each channel frequency within a certain interval through a receiver;
a signal level detecting unit for detecting a signal level of each channel by reading a gain value set when sweeping each channel frequency from the receiver; and
a take-over point (TOP) adjusting unit for changing a TOP value of the receiver according to the detected signal level of each channel.

2. The signal processing apparatus according to claim 1, wherein a width of each channel frequency within the certain interval, which is swept by the frequency sweeping unit, is set to an arbitrary value.

3. The signal processing apparatus according to claim 1, wherein the TOP adjusting unit changes the TOP value to a minimum level within the range in which the signal can be detected when a difference in signal level between a specific channel and an adjacent channel among the signal levels of the channels detected by the signal level detecting unit is greater than a first threshold and the signal level of the specific channel is greater than a second threshold.

4. The signal processing apparatus according to claim 1, wherein the TOP adjusting unit changes the TOP value to a maximum level within the range in which linearity of the receiver is maintained when the difference in the signal level between the specific channel and the adjacent channel among the signal levels of the channels detected by the signal level detecting unit is greater than the first threshold and the signal level of the specific channel is less than a third threshold.

5. The signal processing apparatus according to claim 1, wherein the signal processing apparatus and the receiver transmit the signal to each other through any one communication interface line of a universal asynchronous receiver/transmitter (UART), a serial peripheral interface (SPI), and an inter-integrated circuit (I2C).

6. The signal processing apparatus according to claim 1, wherein the certain interval is a satellite broadcasting frequency band.

7. A system for automatic gain control comprising:
a first amplifier for amplifying a radio frequency (RF) signal received from an antenna;
a mixer for down-converting a frequency of the amplified signal;
a band pass filter for selecting and passing a specific channel frequency among the down-converted signals;
a second amplifier for amplifying the specific channel signal passing through the band pass filter to output the amplified signal to the outside;
a gain controller for setting gain values of the first and second amplifiers according to a signal applied from the outside; and
a signal processing apparatus for changing a TOP value of the gain controller according to signal levels of a specific channel and an adjacent channel.

8. The system for automatic gain control according to claim 7, further comprising:
a local oscillator for generating a predetermined oscillation frequency source according to an external control voltage Vc to output the oscillation frequency source to the mixer; and
a phase locked loop (PLL) for outputting the control voltage Vc to the local oscillator, wherein the control voltage Vc of the PLL varies according to a signal S applied from the signal processing apparatus.

9. The system for automatic gain control according to claim 8, wherein the signal processing apparatus comprises:
a frequency sweeping unit for outputting the signal S for varying the control voltage Vc of the PLL to sweep each channel frequency within a certain interval through the first amplifier, the mixer, the band pass filter, and the second amplifier;
a signal level detecting unit for detecting the signal level of each channel by reading the gain value of each amplifier set when sweeping each channel frequency from the gain controller; and
a TOP adjusting unit for changing the TOP value of the gain controller according to the detected signal level of each channel.

10. The system for automatic gain control according to claim 9, wherein the TOP adjusting unit changes the TOP value to a minimum level within the range in which the signal can be detected when a difference in the signal level between the specific channel and the adjacent channel among the signal levels of the channels detected by the signal level detecting unit is greater than a first threshold TH1 and the signal level of the specific channel is greater than a second threshold TH2.

11. The system for automatic gain control according to claim 9, wherein the TOP adjusting unit maintains the TOP value to an existing value when the difference in the signal level between the specific channel and the adjacent channel among the signal levels of the channels detected by the signal level detecting unit is less than the first threshold TH1 or the signal level of the specific channel is less than the second threshold TH2.

12. The system for automatic gain control according to claim 7, wherein the mixer outputs an intermediate frequency (IF) band signal by down-converting the frequency of the amplified signal.

13. A system for automatic gain control comprising:
a first amplifier for amplifying an RF signal received from an antenna;
a mixer for down-converting a frequency of the amplified signal;
a band pass filter for selecting and passing a specific channel frequency among the down-converted signals;
a second amplifier for amplifying the specific channel signal passing through the band pass filter to output the amplified signal to the outside;
a gain controller for adjusting a gain value of the first amplifier according to a received signal strength indication (RSSI) value of the first amplifier and setting a gain value of the second amplifier according to an RSSI value of the second amplifier; and
a signal processing apparatus for changing a TOP value of the gain controller according to signal levels of a specific channel and an adjacent channel.

14. The system for automatic gain control according to claim 13, further comprising:
a local oscillator for generating a predetermined oscillation frequency source according to a control voltage to output the oscillation frequency source to the mixer; and
a PLL for outputting the control voltage Vc to the local oscillator, wherein the control voltage Vc of the PLL varies according to a signal S applied from the signal processing apparatus.

15. The system for automatic gain control according to claim 14, wherein the signal processing apparatus comprises:
a frequency sweeping unit for outputting a control signal for varying the control voltage Vc of the PLL to sweep each channel frequency within a certain interval through the first amplifier, the mixer, the band pass filter, and the second amplifier;
a signal level detecting unit for detecting the signal level of each channel by reading the gain value of each amplifier set when sweeping each channel frequency from the gain controller; and
a TOP adjusting unit for changing the TOP value of the gain controller according to the detected signal level of each channel.

16. The system for automatic gain control according to claim 15, wherein the TOP adjusting unit changes the TOP value to a maximum level within the range in which linearity of a receiver is maintained when a difference in the signal level between the specific channel and the adjacent channel among the signal levels of the channels detected by the signal level detecting unit is greater than a first threshold TH1 and the signal level of the specific channel is less than a third threshold TH3.

17. The system for automatic gain control according to claim 15, wherein the TOP adjusting unit maintains the TOP value to an existing value when the difference in the signal level between the specific channel and the adjacent channel among the signal levels of the channels detected by the signal level detecting unit is less than the first threshold TH1 or the signal level of the specific channel exceeds the third threshold TH3.

18. A method for automatic gain control of a system for automatic gain control comprising a first amplifier, a mixer, a band pass filter, a second amplifier, a gain controller, and a signal processing apparatus, wherein the gain controller sets gain values of the first and second amplifiers according to a signal applied from the outside, comprising:
(a) detecting the highest signal level (hereinafter, Max. Level value) among the signal levels of channels within a certain interval;
(b) detecting a signal level (hereinafter, Cur. Level value) of a specific channel;
(c) determining whether a difference between the Cur. Level value and the Max. Level value is greater than a first threshold TH1;
(d) determining whether the Cur. Level value is greater than a second threshold TH2 when the difference between the Cur. Level value and the Max. Level value is greater than the first threshold TH1 in the step (c); and
(e) changing a TOP value to a minimum level within the range in which the signal can be detected when the Cur. Level value is greater than the second threshold TH2.

19. The method for automatic gain control according to claim 18, wherein the step (a) is performed through:
(a1) initializing the Max. Level value to an arbitrary value;
(a2) sweeping an nth channel frequency among the channels within the certain interval;
(a3) detecting a signal level (hereinafter, n. Level value) of the nth channel;
(a4) determining whether the n. Level value exceeds the Max. Level value;
(a5) changing the Max. Level value to the n. Level value when the n. Level value exceeds the Max. Level value in the step (a4); and
(a6) determining whether the nth channel and an mth channel are equal to each other.

20. The method for automatic gain control according to claim 19, wherein when the n.
Level value is less than the Max. Level value in the step (a4), the flow branches to the step (a6).

21. The method for automatic gain control according to claim 19, wherein when the nth channel and the mth channel are equal to each other in the step (a6), the process of detecting the Max. Level value is finished, and when the nth channel and the mth channel are not equal to each other, the flow branches to the step (a2) under the condition of n=n+1.

22. The method for automatic gain control according to claim 18, wherein when the difference between the Cur. Level value and the Max. Level value is less than the first threshold TH1 in the step (c) or when the Cur. Level value is less than the second threshold TH2 in the step (d), the TOP value is maintained to an existing value.

23. A method for automatic gain control of a system for automatic gain control comprising a first amplifier, a mixer, a band pass filter, a second amplifier, a gain controller, and a signal processing apparatus, wherein the gain controller adjusts a gain value of the first amplifier according to an RSSI value of the first amplifier and adjusts a gain value of the second amplifier according to an RSSI value of the second amplifier, comprising:
(a) detecting the highest signal level (hereinafter, Max. Level value) among the signal levels of channels within a certain interval;
(b) detecting a signal level (hereinafter, Cur. Level value) of a specific channel;
(c) determining whether a difference between the Cur. Level value and the Max. Level value is greater than a first threshold TH1;
(d) determining whether the Cur. Level value is less than a third threshold TH3 when the difference between the Cur. Level value and the Max. Level value is greater than the first threshold TH1 in the step (c); and
(e) changing a TOP value to a maximum level within the range in which linearity characteristics of a receiver are maintained when the Cur. Level value is less than the third threshold TH3.

24. The method for automatic gain control according to claim 23, wherein when the difference between the Cur. Level value and the Max. Level value is less than the first threshold TH1 in the step (c) or when the Cur. Level value exceeds the third threshold TH3 in the step (d), the TOP value is maintained to an existing value.
